# EUROPÄISCHE PATENTSCHRIFT

(11) **EP 0 400 193 B1**
(45) Veröffentlichungstag und Bekanntmachung des Hinweises auf die Patenterteilung: **09.02.1994**
(21) Anmeldenummer: 89110028.1
(22) Anmeldetag: 02.06.1989
(51) Int. Cl.: H05K 5/00, H01L 31/0203

(54) **Sensoreinrichtung**
Sensing device
Dispositif capteur

(43) Veröffentlichungstag der Anmeldung: 05.12.1990
(73) Patentinhaber: SIEMENS AKTIENGESELLSCHAFT, 80333 München (DE)
(72) Erfinder: Dangschat, Rainer, Dipl.-Ing. (FH), D-8011 Landsham (DE)

(56) Entgegenhaltungen:
- EP-A- 0 071 233
- EP-A- 0 107 480
- EP-A- 0 273 364
- DE-A- 2 829 260
- DE-A- 3 320 953
- DE-A- 3 603 912
- US-A- 4 675 718
- PATENT ABSTRACTS OF JAPAN, Band 9, Nr. 208 (E-338)[1931], 24. August 1985;& JP-A-60 70 784
- PATENT ABSTRACTS OF JAPAN, Band 8, Nr. 194 (E-264)[1631], 6. September 1984;& JP-A-59 80 979
- PATENT ABSTRACTS OF JAPAN, Band 10, Nr. 325 (E-451)[2381], 6. November 1986;& JP-A-61 131 560
- PATENT ABSTRACTS OF JAPAN, Band 11, Nr. 309 (E-547)[2756], 8. October 1987;& JP-A-62 102 548

## Beschreibung

Die Erfindung betrifft eine Sensoreinrichtung nach dem Oberbegriff des Anspruchs 1.

Solche Sensoreinrichtungen sind allgemein bekannt. In diesen Sensoreinrichtungen kann als Halbleitersensor beispielsweise ein Drucksensor, ein Temperatursensor oder eine lichtempfindliche Anordnung, wie etwa eine Infrarot-Empfangsdiode verwendet werden. Dieser Halbleitersensor ist mit einer Verstärkeranordnung verbunden, so daß an einem Ausgangsanschluß der Sensoreinrichtung, die mit der Ausgangsklemme der Verstärkeranordnung verbunden ist, ein verstärktes Sensorsignal abgegriffen werden kann. Über Versorgungsanschlüsse erfolgt die Stromversorgung der Sensoreinrichtung. In den heute üblichen Sensoreinrichtungen sind der Halbleitersensor und die Verstärkeranordnung jeweils in einem eigenen Gehäuse untergebracht und auf einer mit Leiterbahnen versehenen Trägerplatte angeordnet, eine sogenannte gedruckte Schaltung.

Der Erfindung liegt die Aufgabe zugrunde, eine ein bereits verstärktes Sensorsignal liefernde Sensoreinrichtung anzugeben, die im Vergleich zu den bisher bekannten und in gedruckter Schaltungstechnik ausgeführten Sensoreinrichtungen weniger Platz beansprucht, störunanfälliger und in einfacherer Weise herstellbar ist.

Diese Aufgabe wird bei einer Sensoreinrichtung nach dem Oberbegriff des Anspruchs 1 durch dessen kennzeichnende Merkmale gelöst.

Weiterbildungen der Erfindung sind Gegenstand der Unteransprüche.

Die erfindungsgemäße Sensoreinrichtung sieht also vor, daß der Halbleitersensor und die Verstärkeranordnung jeweils als Chip auf mindestens einer Kontaktzunge einer Kontaktspinne angeordnet und im wesentlichen über Kontaktbändchen elektrisch mit den Versorgungsanschlüssen und dem Ausgangsanschluß der Sensoreinrichtung verbunden wird. Durch die Verwendung von Chips der Verstärkeranordnung und des Halbleitersensors kann die Sensoreinrichtung in ihren Abmessungen wesentlich kleiner aufgebaut werden als dies mit den üblicherweise gedruckten Schaltungen möglich ist. Diese geringeren Abmessungen führen auch dazu, daß die Sensoreinrichtung gegenüber induzierten Störspannungen unempfindlicher ist, da die Zuleitungen und elektrischen Verbindungen kürzer als bei gedruckten Schaltungen ausgeführt werden können. Die im Vergleich zur gesamten Sensoreinrichtung relativ groß ausgeführte Kontaktzunge bzw. Kontaktzungen führt zusätzlich zu einer Abschirmwirkung. Ein wesentlicher Vorteil der erfindungsgemäßen Sensoreinrichtung ist auch darin zu sehen, daß dieser in einer reinen Halbleiter-Fertigungstechnologie herstellbar ist.

Die Erfindung wird im folgenden anhand zweier Ausführungsbeispiele im Zusammenhang mit neun Figuren näher erläutert. Es zeigen:
- FIG 1: eine Schaltungsanordnung für eine bekannte Sensoreinrichtung,
- FIG 2: eine erste erfindungsgemäße Ausführungsform der Sensoreinrichtung,
- FIG 3: eine erste Ausführungsform einer Abschirmvorrichtung für eine erfindungsgemäße Sensoreinrichtung,
- FIG 4: eine zweite Ausführungsform einer Abschirmvorrichtung für eine erfindungsgemäße Sensoreinrichtung,
- FIG 5: ein Metallband, aus dem eine erste Ausführungsform einer Kontaktspinne mit einer einzigen Kontaktzunge nach FIG 2 herausgetrennt wird,
- FIG 6: die Kontaktspinne nach FIG 5, auf der bereits der Halbleitersensor und die Verstärkeranordnung jeweils als Chip aufgebracht sowie weitere elektrische Bauelemente mit Kontaktbändchen verbunden sind,
- FIG 7: eine zweite Ausführungsform einer aus einem Metallband heraustrennbaren Kontaktspinne, die jetzt zwei Kontaktzungen aufweist,
- FIG 8: die Kontaktspinne nach FIG 7, auf der bereits der Halbleitersensor und die Verstärkeranordnung jeweils als Chip aufgebracht sind und
- FIG 9: eine in Vergußmasse eingebettete und vom Metallband getrennte Sensoreinrichtung nach FIG 8.

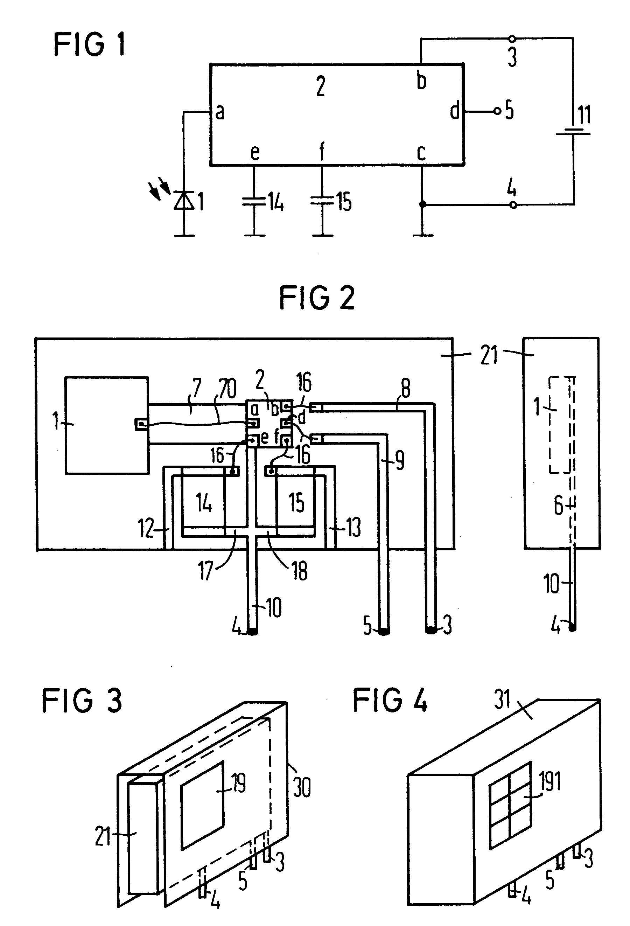

In FIG 1 ist die Schaltungsanordnung einer an sich bekannten Sensoreinrichtung mit einem Halbleitersensor 1 und einer Verstärkeranordnung 2, z. B. den integrierten Baustein TDA 4065 von Siemens, sowie einer Spannungsquelle 11 und weiterer elektrischer Bauelemente 14, 15 dargestellt. Als Halbleitersensor 1 ist in diesem Ausführungsbeispiel einer Schaltungsanordnung für eine Sensoreinrichtung eine lichtempfindliche Anordnung, z. B. eine Infrarot-Empfangsdiode, vorgesehen, die mit ihren beiden Anschlüssen zwischen Bezugspotential und einer ersten Klemme a der Verstärkeranordnung 2 geschaltet ist. Die Verstärkeranordnung 2 verfügt über weitere Klemmen b und c, an die über Versorgungsanschlüsse 3, 4 eine Spannungsquelle 11 geschaltet ist. Eine weitere Klemme d der Verstärkeranordnung 2 ist mit dem Ausgangsanschluß 5 der Sensoreinrichtung verbunden. Darüber hinaus weist die Verstärkeranordnung 2 weitere Klemmen e, f auf, an die beispielsweise jeweils eine Kapazität mit einer ihrer Klemmen angeschlossen ist, wobei deren anderen Anschlüsse mit Bezugspotential verbunden sind. Der Versorgungsanschluß 4 liegt ebenfalls auf Bezugspotential. Am Ausgangsanschluß 5 der Sensoreinrichtung ist ein durch die Verstärkeranordnung 2 verstärktes Sensorsignal, das der Halbleitersensor 1 beispielsweise bei Lichteinfall erzeugt, abgreifbar.

In FIG 2 ist ein Ausführungsbeispiel für eine erfindungsgemäße Sensoreinrichtung dargestellt, welche als ein einziges Bauelement mit drei extern zugänglichen Anschlüssen, nämlich den Versorgungsanschlüssen 3 und 4 sowie dem Ausgangsanschluß 5 ausgebildet ist. Als Halbleitersensor 1 wird im folgenden eine Infrarot-Empfangsdiode auf die die Erfindung jedoch nicht beschränkt ist, vorgesehen, deren ein mit Bezugspotential zu verbindende Anschluß als- Kontaktfläche ausgebildet ist. Die lichtempfindliche Fläche der Infrarot-Empfangsdiode ist auf der der Kontaktfläche gegenüberliegenden Oberfläche des Chips angeordnet. Als Halbleitersensoren 1 können auch Drucksensoren, Temperatursensoren, Feuchtigkeitssensoren usw. eingesetzt werden.

Die Sensoreinrichtung nach FIG 2 weist eine Kontaktspinne 6 mit einer Kontaktzunge 7 und Kontaktbändchen 8, 9, 10 auf. Die Kontaktzunge 7 verfügt über zwei Aufnahmeflächen, auf deren erster Aufnahmefläche ein Chip der Infrarot-Empfangsdiode 1 und auf deren anderer Aufnahmefläche ein Chip der Verstärkeranordnung 2 angeordnet und gehaltert ist. Zweckmäßigerweise ist die Kontaktzunge 7 mit dem Kontaktbändchen 10 einstückig ausgebildet und zum Anschluß des Bezugspotentials der Spannungsquelle vorgesehen. Damit kann die Infrarot-Empfangsdiode 1 mit ihrem auf Bezugspotential zu legenden Anschluß, der auf der Unterseite des Chips als Kontaktfläche ausgebildet ist, und die ebenfalls als Kontaktfläche ausgebildete Klemme c des Chips der Verstärkeranordnung 2 leitend durch Löten oder mittels eines Leitklebers auf die Kontaktzunge 7 aufgebracht sein. Es ist jedoch auch möglich, das Chip der Infrarot-Empfangsdiode 1 und/oder das Chip der Verstärkeranordnung 2 isoliert auf der Kontaktzunge 7 aufzubringen, z. B. mit einem isolierenden Kleber oder durch Zwischenlegen einer Isolierschicht zwischen Kontaktzunge 7 und Chip. Dies ist besonders dann der Fall, wenn das Chip keine Massefläche aufweist. Die elektrische Verbindung des Masseanschlusses der Verstärkeranordnung 2 und/oder der Infrarot-Empfangsdiode 1 mit der übrigen Schaltungsanordnung ist dann auf andere Weise, z. B. mit Bonddrähten, herzustellen. Die beiden anderen Kontaktbändchen 8 und 9 sind an ihren ersten Enden über Bonddrähte 16 mit den Klemmen b und d der Verstärkeranordnung elektrisch leitend verbunden. Die nicht mit den Klemmen b, c, d der Verstärkeranordnung 2 verbundenen Enden der Kontaktbändchen 8, 10 und 9 bilden zugleich die Versorgungsanschlüsse 3 und 4 sowie den Ausgangsanschluß 5.

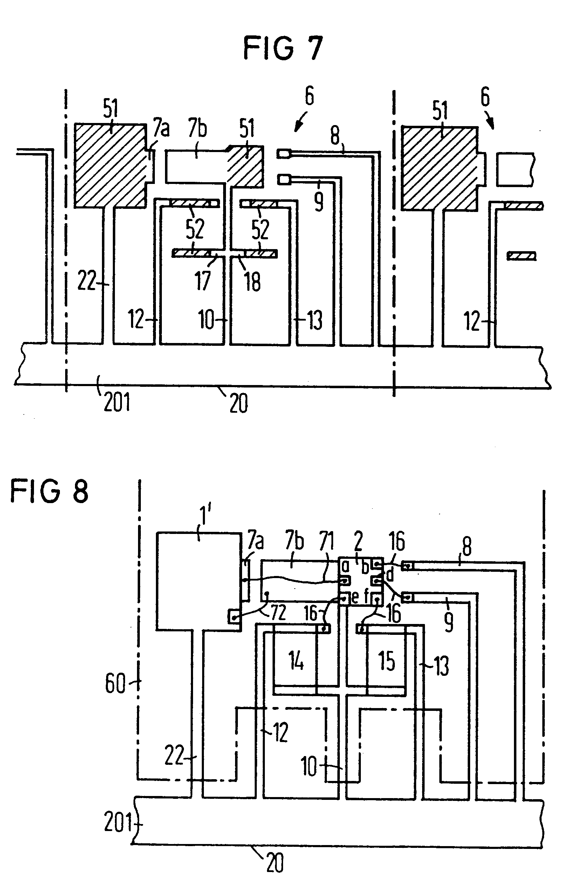

Weist die Infrarot-Empfangsdiode zwar eine Kontaktfläche auf, und darf diese Kontaktfläche nicht mit Bezugspotential verbunden sein, so werden erfindungsgemäß zwei Kontaktzungen vorgesehen. Einzelheiten dazu werden im Zusammenhang mit den FIG 7 bis 9 noch eingehend erläutert.

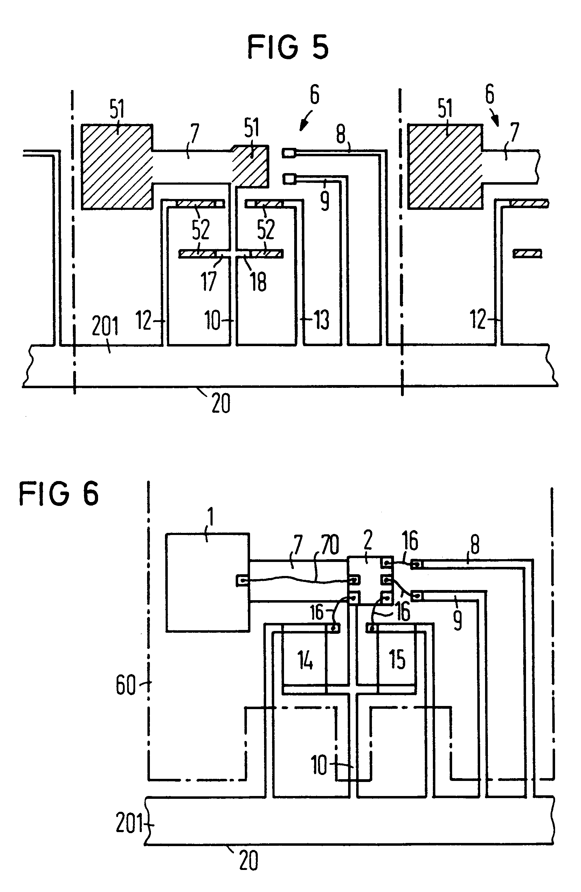

Entsprechend der in FIG 1 an die Verstärkeranordnung 2 angeschlossenen weiteren elektrischen Bauelemente 14 und 15, z. B. Kondensatoren, können in der in FIG 2 gezeigten Sensoreinrichtung weitere Kontaktbändchen 12, 13, 17 und 18 vorgesehen werden, über die die weiteren elektrischen Bauelemente 14 und 15 in die Sensoreinrichtung integrierbar sind. Dazu sind in diesem Ausführungsbeispiel die weiteren Kontaktbändchen 12, 13, 17 und 18 - deren Herstellung im Zusammenhang mit FIG 5 und 6 noch eingehend zu beschreiben ist - vorgesehen. So sind die weiteren Kontaktbändchen 17 und 18 beispielsweise einstückig an das auf Bezugspotential zu legende Kontaktbändchen 10 angeformt, während die weiteren Kontaktbändchen 12 und 13 mit den Klemmen e und f der Verstärkeranordnung 2 über Bonddrähte 16 verbunden sind. Zwischen die Kontaktbändchen 13 und 18 sowie 12 und 17 ist jeweils eines der weiteren elektrischen Bauelemente 14 und 15 geschaltet.

Zweckmäßigerweise werden die Kontaktbändchen 8, 9 und 10 in der Sensoreinrichtung derart angeordnet, daß ihre die Versorgungsanschlüsse 3 und 4 und den Ausgangsanschluß 5 bildenden Enden parallel zueinander liegen um so eine einfache Zugriffsmöglichkeit auf die Sensoreinrichtung zu gewährleisten.

Die erfindungsgemäße Sensoreinrichtung ist in eine isolierende Vergußmasse 21 derart eingebettet, daß die die Versorgungsanschlüsse 3 und 4 sowie den Ausgangsanschluß 5 bildenden Enden der Kontaktbändchen 8 und 10 sowie 9 teilweise herausragen und der Halbleitersensor 1 in seiner Empfindlichkeit nicht behindert ist. Dazu kann bei der Verwendung von lichtempfindlichen Halbleitersensoren die Vergußmasse 21 lichtdurchlässig ausgebildet sein. Die Vergußmasse 21 kann beispielsweise schwarz-rot eingefärbt sein und damit infrarotdurchlässig. Sichtbares Licht kann jedoch nicht durch die Vergußmasse 21 dringen. Die Vergußmasse 21 dient im wesentlichen auch der mechanischen Stabilisierung der gesamten Sensoreinrichtung sowie der elektrischen Isolierung der einzelnen Bauelemente und der Kontaktspinne.

Um die erfindungsgemäße Sensoreinrichtung bei Betrieb vor störenden elektrischen und magnetischen Feldern und/oder vor unerwünschten Lichteinfall bei lichtempfindlichen Sensoreinrichtungen zu schützen, kann eine Abschirmvorrichtung vorgesehen werden, die - wie in FIG 3 gezeigt beispielsweise als U-förmiges Metallband mit einer für den Halbleitersensor 1 vorgesehenen Fensteröffnung 19 ausgebildet ist. Die schmalen Stirnseiten sind dann offen.

In FIG 4 ist eine ähnliche Abschirmvorrichtung wie in FIG 3 dargestellt, die sich jetzt jedoch dadurch unterscheidet, daß die Stirnseiten ebenfalls mit Metallblech umschlossen sind und die Öffnung in der Abschirmvorrichtung für den Halbleitersensor 1 als Gitterfenster 191 ausgebildet ist.

Eine weitere Möglichkeit eine Abschirmvorrichtung für die Sensoreinrichtung vorzusehen besteht beispielsweise darin, die Vergußmasse 21 an ihrer Oberfläche mit einer Metallisierungsschicht zu überziehen. Diese Metallisierungsschicht darf selbstverständlich die Empfindlichkeit des Halbleitersensors 1 sowie die Versorgungsanschlüsse 3 und 4 und den Ausgangsanschluß 5 nicht behindern. Dazu wird zweckmäßigerweise an diesen Stellen von einer Metallisierungsschicht abgesehen.

In vielen Fällen kann auch auf die Verwendung einer gesonderten Abschirmvorrichtung ganz verzichtet werden, da die erfindungsgemäße Sensoreinrichtung gegenüber den bisher bekannten Sensoreinrichtungen in ihren Abmessungen wesentlich kleiner und damit gegenüber induzierten Störspannungen unempfindlicher ist. Die relativ große Metallfläche der Kontaktzunge 7 führt ebenfalls zu einer Abschirmwirkung.

In FIG 5 ist ein Ausschnitt aus einem Metallband 20 gezeigt, aus dem bereits Teile des Metallbandes nach Art der in FIG 2 dargestellten Kontaktspinne 6 herausgetrennt sind. Die Kontaktbändchen 8, 9, 10, 12 und 13 sind jedoch noch mit einem Metallbandrandstreifen 201 einstückig verbunden, so daß die Kontaktspinne 6 vom Metallbandrandstreifen 201 gehaltert wird. Die Kontaktbändchen 17 und 18 sind - wie im Zusammenhang mit FIG 2 bereits erläutert - einstückig an das Kontaktbändchen 10 angeformt. Das Metallband 20 weist eine Vielzahl solcher Kontaktspinnen 6 auf.

Die derartig noch am Metallbandrandstreifen 201 hängende Kontaktspinne 6 kann jetzt mit den Chips des Halbleitersensors 1 und der Verstärkeranordnung 2 und gegebenenfalls den erforderlichen weiteren elektrischen Bauelementen 14 und 15 (vgl. FIG 6), die für die Funktion der Sensoreinrichtung notwendig sein können, bestückt werden. Dazu werden die Chips des Halbleitersensors 1 und der Verstärkeranordnung 2 auf die in FIG 5 schraffiert gekennzeichneten und mit Bezugszeichen 51 versehenen Flächen der Kontaktzunge 7 aufgeklebt, beispielsweise mit einem leitfähigen Kleber, oder aber aufgelötet. Die Kontaktierung 14 und 15 der gegebenenfalls notwendigen weiteren elektrischen Bauelemente kann ebenfalls entweder mit einem leitfähigen Kleber oder mit einem Lötmittel auf die mit einer Schraffur versehenen und mit Bezugszeichen 52 gekennzeichneten Abschnitte der Kontaktbändchen 12, 13, 17 und 18 aufgebracht werden. Das Aufbringen der genannten Bauelemente kann ähnlich wie in der SMD (surface mounted device)-Technik mit Lötpaste erfolgen. Prinzipiell kann jede Löttechnik verwendet werden.

Nach dem Bestücken der Kontaktspinne 6 mit den Chips des Halbleitersensors 1 und der Verstärkeranordnung 2 sowie der gegebenenfalls notwendigen weiteren elektrischen Bauelemente 14 und 15 werden die Kontaktbändchen 8, 9, 10, 12 und 13 - wie in FIG 6 dargestellt - über Bonddrähte 16 mit der Verstärkeranordnung 2 elektrisch verbunden. Auch die elektrische Verbindung des Anschlusses a mit dem Halbleitersensor 1 erfolgt über einen weiteren Bonddraht 70. Anschließend wird die Sensoreinrichtung in die bereits erwähnte isolierende Vergußmasse 21 eingebettet, so daß die die Versorgungsanschlüsse 3, 4 und den Ausgangsanschluß 5 bildenden Kontaktbändchen 8, 10 und 9 teilweise herausragen und der Halbleitersensor 1 in seiner Empfindlichkeit nicht behindert ist.

Anschließend werden die Kontaktbändchen 8, 9, 10, 12 und 13, wie mit der strichpunktierten Schnittlinie 60 in FIG 6 dargestellt, von dem Metallbandrandstreifen des Metallbandes 20 getrennt, so daß lediglich die Kontaktbändchen 8, 10, 9 für die Versorgungsanschlüsse 3 und 4 und den Ausgangsanschluß 5 der Sensoreinrichtung aus der Vergußmasse 21 hervorstehen. Zum Schluß kann die Sensoreinrichtung in eine Abschirmvorrichtung, wie diese im Zusammenhang mit FIG 3 und 4 vorgestellt wurde, eingebaut werden.

Anstelle der in den Figuren beispielhaft angegebenen Bonddrähte 16, die die Kontaktbändchen 8, 9, 12 und 13 mit Klemmen der Verstärkeranordnung 2 elektrisch verbinden, kann auch vorgesehen werden, daß die Kontaktbändchen 8, 9, 12 und 13 stoffschlüssig mit den Klemmen b, d, e, f verbunden sind. Dazu müssen die Kontaktbändchen 8, 9, 12, 13 mit ihren in Richtung der Verstärkeranordnung 2 zeigenden Enden beispielsweise an die Klemmen b, d, e, f der Verstärkeranordnung direkt angelötet oder mit einem leitfähigen Kleber angeklebt werden.

In einem zweiten Ausführungsbeispiel einer erfindungsgemäßen Sensoreinrichtung, die anhand der Figuren 7, 8 und 9 nachfolgend beschrieben wird, weist das Chip der Halbleitersensoranordnung 1 eine Kontaktfläche auf, die im Gegensatz zum ersten Ausführungsbeispiel nicht mit Bezugspotential verbunden werden darf. Ein solches Chip des Halbleitersensors 1 kann beispielsweise ein Chip einer Infrarot-Empfangsdiode sein, deren Katodenanschluß als Kontaktfläche auf einer Hauptfläche des Chips großflächig ausgebildet ist, während deren Anodenanschluß auf der der Kontaktfläche gegenüberliegende Hauptfläche als kleine Kontaktklemme realisiert ist. Bei diesem Ausführungsbeispiel darf deshalb der Anodenanschluß der Infrarot-Empfangsdiode nicht mit Bezugspotential verbunden werden. Eine elektrisch leitende Verbindung der Kontaktfläche des Chips der Infrarot-Diode 1 mit der auf Bezugspotential liegenden Kontaktzungen muß also vermieden werden. Dazu weist die Kontaktspinne jetzt erfindungsgemäß zwei Kontaktzungen auf.

In FIG 7 ist wieder eine aus einem Metallband heraustrennbare Kontaktspinne 6 gezeigt, die sich von der in FIG 5 dargestellten Kontaktspinne lediglich durch eine andere Ausgestaltung der Kontaktzunge unterscheidet. Mit dem bereits bekannten Bezugszeichen werden gleiche Teile weiter bezeichnet. Die Kontaktspinne 6 weist jetzt zwei voneinander getrennte Kontaktzungen auf, nämlich eine erste Kontaktzunge 7a, die zur Aufnahme des Chips der Infrarot-Empfangsdiode 1 vorgesehen ist und eine zweite Kontaktzunge 7b, auf die das Chip der Verstärkeranordnung 2 angeordnet wird. Gehaltert wird die Kontaktzunge 7a durch einen Steg 22, der mit dem Metallbandrandstreifen 201 einstückig verbunden ist.

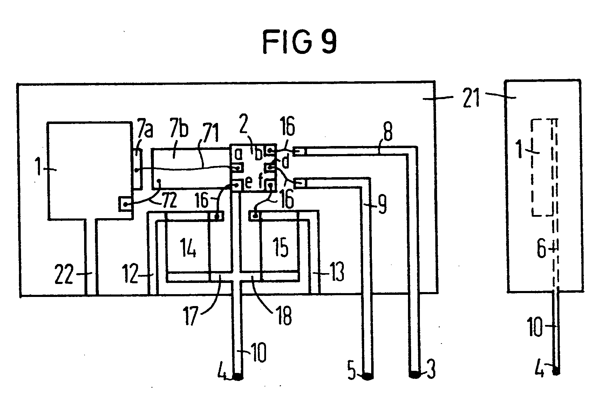

In FIG 8 sind die elektrischen Bauelemente bereits auf die Kontaktspinne 6 aufgebracht, so wie es im Zusammenhang mit FIG 6 ausführlich beschrieben worden ist. Im Unterschied zu FIG 6 ist das Chip der Infrarot-Empfangsdiode 1 mit zwei Bonddrähten 71 und 72 an das Chip der Verstärkeranordnung 2 angeschlossen. Das an die Klemme a des Chips der Verstärkeranordnung 2 angeschlossene eine Ende des Bonddrahts 71 ist mit seinem anderen Ende leitend mit der Kontaktzunge 7a in Verbindung, während durch den weiteren Bonddraht 72 die Kontaktzunge 7b mit dem Anodenanschluß der Infrarot-Empfangsdiode 1 leitend verbunden ist. Nachdem sämtliche elektrischen Verbindungen in der Sensoreinrichtung hergestellt sind, kann die Sensoreinrichtung in die isolierende Vergußmasse (vgl. dazu FIG 9) in der beschriebenen Weise eingebettet und schließlich gemäß der Schnittlinie 60 vom Metallbandrandstreifen 201 abgetrennt werden. Zu beachten ist, daß die erste Kontaktzunge 7a ausschließlich durch die Bonddrähte 71 und 72 sowie durch die sie umgebende isolierende Vergußmasse 21 gehaltert wird.

Mit der erfindungsgemäßen Sensoreinrichtung wird also ein einziges Bauelement vorgesehen, das lediglich drei Anschlüsse aufweist, von denen zwei Anschlüsse die Versorgungsanschlüsse darstellen und an dem dritten Anschluß ein verstärktes Sensorsignal abgreifbar ist.

## Patentansprüche

1. Sensoreinrichtung mit mindestens:
- einem Halbleitersensor (1),
- eine mit dem Halbleitersensor (1) elektrisch verbundene und mit Klemmen (a, b, c, d) versehene Verstärkeranordnung (2),
- Versorgungsanschlüsse (3, 4), die zum Anlegen einer Spannungsquelle (11) vorgesehen und mit Klemmen (b, c) der Verstärkeranordnung (2) elektrisch verbunden sind,
- einem Ausgangsanschluß (5), der mit der ein verstärktes Sensorsignal liefernden Klemme (d) der Verstärkeranordnung (2) verbunden ist,
**gekennzeichnet** durch die Merkmale
- daß eine Kontaktspinne (6) mit mindestens einer Kontaktzunge (7) und Kontaktbändchen (8, 9, 10) vorgesehen ist,
- daß auf der einzigen Kontaktzunge (7) oder den Kontaktzungen (7a, 7b) der Halbleitersensor (1) und die Verstärkeranordnung (2) jeweils als Chip angeordnet und gehaltert sind,
- daß die Kontaktbändchen (8, 9, 10) durch jeweils eine elektrische Verbindung mit Klemmen (b, c, d) der Verstärkeranordnung (2) gehaltert sind und zugleich als Versorgungsanschlüsse (3, 4) und als Ausgangsanschluß (5) dienen, und
- daß die Sensoreinrichtung in eine isolierende Vergußmasse (21) eingebettet ist.

2. Sensoreinrichtung nach Anspruch 1,
**dadurch gekennzeichnet,**
daß mindestens eine Kontaktzunge (7) mit mindestens einem der Kontaktbändchen (10) einstückig ausgebildet ist.

3. Sensoreinrichtung nach Anspruch 1,
**dadurch gekennzeichnet,**
daß mindestens eine Kontaktzunge (7) mit mindestens einem der Kontaktbändchen (10) einstückig ausgebildet und mit Bezugspotential der Spannungsquelle (11) verbunden ist.

4. Sensoreinrichtung nach einem der Ansprüche 1 bis 3,
**dadurch gekennzeichnet,**
daß weitere Kontaktbändchen (12, 13, 17, 18) vorgesehen sind, über welche zusätzliche elektrische Bauelemente (14, 15) durch elektrische Verbindung an weitere Klemmen (e, f) der Verstärkeranordnung (2) anschließbar sind.

5. Sensoreinrichtung nach einem der Ansprüche 1 bis 4,
**dadurch gekennzeichnet,**
daß die elektrischen Verbindungen der Kontaktbändchen (8, 9, 10, 12, 13) mit Klemmen (a, b, c, d, e, f) der Verstärkeranordnung (2) mindestens teilweise durch Bonddrähte (16) ausgeführt sind.

6. Sensoreinrichtung nach einem der Ansprüche 1 bis 5,
**dadurch gekennzeichnet,**
daß die elektrischen Verbindungen der Kontaktbändchen (8, 9, 10, 12, 13) mit Klemmen (a, b, c, d, e, f) der Verstärkeranordnung (2) mindestens teilweise durch stoffschlüssige Anformung ausgeführt sind.

7. Sensoreinrichtung nach einem der Ansprüche 1 bis 6,
**dadurch gekennzeichnet,**
daß das Chip des Halbleitersensors (1) und das Chip der Verstärkeranordnung (2) auf die einzige gemeinsame Kontaktzunge (7) aufgeklebt oder aufgelötet sind.

8. Sensoreinrichtung nach einem der Ansprüche 1 bis 6,
**dadurch gekennzeichnet,**
daß das Chip des Halbleitersensors (1) auf eine Kontaktzunge (7a) und das Chip der Verstärkeranordnung (2) auf eine andere Kontaktzunge (7b) aufgeklebt oder aufgelötet sind.

9. Sensoreinrichtung nach einem der Ansprüche 1 bis 8,
**dadurch gekennzeichnet,**
daß die Kontaktspinne (6) aus einem Metallband (20) durch formgerechtes Heraustrennen gebildet ist.

10. Sensoreinrichtung nach einem der Ansprüche 1 bis 9,
**dadurch gekennzeichnet,**
daß in die isolierende Vergußmasse (21) die Sensoreinrichtung derart eingebettet ist, daß die die Versorgungsanschlüsse (3, 4) und den Ausgangsanschluß (5) bildenden Kontaktbändchen (8, 10 und 9) teilweise herausragen und der Halbleitersensor (1) in seiner Empfindlichkeit nicht behindert ist.

11. Sensoreinrichtung nach einem der Ansprüche 1 bis 10,
**dadurch gekennzeichnet,**
daß der Halbleitersensor (1) eine lichtempfindliche Anordnung, insbesondere eine Infrarot-Empfangsdiode, ist.

12. Sensoreinrichtung nach Anspruch 10 und 11,
**dadurch gekennzeichnet,**
daß die isolierende Vergußmasse (21) lichtdurchlässig, insbesondere infrarotlichtdurchlässig ist.

13. Sensoreinrichtung nach einem der Ansprüche 1 bis 12,
**dadurch gekennzeichnet,**
daß eine Abschirmvorrichtung (30; 31) vorgesehen ist, die geeignet ist, die Sensoreinrichtung vor störenden elektrischen und magnetischen Feldern und/oder Lichteinfall zu schützen.

## Claims

1. Sensor device comprising at least:
- one semiconductor sensor (1),
- one amplifier arrangement (2) which is electrically connected to the semiconductor sensor (1) and provided with terminals (a, b, c, d),
- supply connections (3,4) which are provided for the connection of a voltage source (11) and are connected to terminals (b, c) of the amplifier arrangement (2),
- an output connection (5) which is connected to that terminal (d) of the amplifier arrangement (2) which supplies an amplified sensor signal,
characterized by the features
- that a contact spider (6) is provided which has at least one contact tongue (7) and contact strips (8, 9, 10),
- that the semiconductor sensor (1) and the amplifier arrangement (2) are in each case disposed and retained as a chip on the sole contact tongue (7) or the contact tongues (7a, 7b),
- that the contact strips (8, 9, 10) are retained by one electrical connection in each case to terminals (b, c, d) of the amplifier arrangement (2) and simultaneously serve as supply connections (3, 4) and as output connection (5), and
- that the sensor device is embedded in an insulating encapsulating compound (21).

2. Sensor device according to Claim 1, characterized in that at least one contact tongue (7) is integrally formed with at least one of the contact strips (10).

3. Sensor device according to Claim 1, characterized in that at least one contact tongue (7) is integrally formed with at least one of the contact strips (10) and is connected to a reference potential of the voltage source (11).

4. Sensor device according to one of Claims 1 to 3, characterized in that further contact strips (12, 13, 17, 18) are provided by means of which additional electrical components (14, 15) can be connected to further terminals (e, f) of the amplifier arrangement (2) by electrical connection.

5. Sensor device according to one of Claims 1 to 4, characterized in that the electrical connections of the contact strips (8, 9, 10, 12, 13) to terminals (a, b, c, d, e, f) of the amplifier arrangement (2) are formed at least in some cases by bonding wires (16).

6. Sensor device according to one of Claims 1 to 5, characterized in that the electrical connections of the contact strips (8, 9, 10, 12, 13) to terminals (a, b, c, d, e, f) of the amplifier arrangement (2) are formed at least in some cases by materially connective moulding-on.

7. Sensor device according to one of Claims 1 to 6, characterized in that the chip of the semiconductor sensor (1) and the chip of the amplifier arrangement (2) are bonded or soldered onto the sole, common contact tongue (7).

8. Sensor device according to one of Claims 1 to 6, characterized in that the chip of the semiconductor sensor (1) is bonded or soldered onto a contact tongue (7a) and the chip of the amplifier arrangement (2) is bonded or soldered onto another contact tongue (7b).

9. Sensor device according to one of Claims 1 to 8, characterized in that the contact spider (6) is formed from a metal strip (20) by cutting out in the appropriate shape.

10. Sensor device according to one of Claims 1 to 9, characterized in that the sensor device is embedded in the insulating encapsulating compound (21) in such a manner that the contact strips (8, 10 and 9) which form the supply connections (3, 4) and the output connection (5) partly project and the sensitivity of the semiconductor sensor (1) is not impeded.

11. Sensor device according to one of Claims 1 to 10, characterized in that the semiconductor sensor (1) is a photosensitive arrangement, in particular an infrared receiving diode.

12. Sensor device according to Claims 10 and 11, characterized in that the insulating encapsulating compound (21) is transparent to light, in particular transparent to infrared light.

13. Sensor device according to one of Claims 1 to 12, characterized in that a screening device (30; 31) is provided which is suitable for protecting the sensor device against interfering electrical and magnetic fields and/or incident light.

## Revendications

1. Dispositif de détection comportant au moins :
- un capteur à semiconducteurs (1),
- un dispositif amplificateur (2) connecté électriquement au capteur à semiconducteurs (1) et muni de bornes (a,b,c, d),
- des raccordements d'alimentation (3,4), qui sont prévues pour le raccordement d'une source de tension (11) et qui sont connectées électriquement à des bornes (b,c) du dispositif amplificateur (2),
- un raccordement de sortie (5), qui est raccordé à la borne (d), qui fournit un signal de détection amplifié, du dispositif amplificateur (2),
caractérisé par les caractéristiques suivantes :
- il est prévu une structure de contact (6) comportant au moins une languette de contact (7) et des bandelettes de contact (8,9,10),
- le capteur à semiconducteurs (1) et le dispositif amplificateur (2) sont disposés et fixés respectivement sous la forme d'une microplaquette sur la languette de contact unique (7) ou sur les languettes de contact (7a,7b),
- les bandelettes de contact (8,9,10) sont fixées par respectivement une liaison électrique à des bornes (b,c,d) du dispositif amplificateur (2) et sont utilisées en même temps en tant que raccordements d'alimentation (3,4) et en tant que raccordement de sortie (5), et
- le dispositif de détection est enrobé dans une composition de scellement (21) isolante.

2. Dispositif de détection suivant la revendication 1, caractérisé par le fait qu'au moins une languette de contact (7) est d'un seul tenant avec au moins l'une des bandelettes de contact (10).

3. Dispositif de détection suivant la revendication 1, caractérisé par le fait qu'au moins une languette de contact (7) est d'un seul tenant avec au moins l'une des bandelettes de contact (10) et est reliée au potentiel de référence de la source de tension (11).

4. Dispositif de détection suivant l'une des revendications 1 à 3, caractérisé par le fait qu'il est prévu d'autres bandelettes de contact (12,13,17,18), au moyen desquelles des composants électriques (14,15) supplémentaires peuvent être raccordés par l'intermédiaire d'une liaison électrique à d'autres bornes (e,f) du dispositif amplificateur (2).

5. Dispositif de détection suivant l'une des revendications 1 à 4, caractérisé par le fait que les liaisons électriques des bandelettes de contact (8,9,10,12,13) munies de bornes (a,b,c,d,e,f) du dispositif amplificateur (2) sont réalisées au moins en partie par des fils de liaison (16).

6. Dispositif de détection suivant l'une des revendications 1 à 5, caractérisé par le fait que les liaisons électriques des bandelettes de contact (8,9,10,12,13) munies de bornes (a,b,c,d,e,f) du dispositif amplificateur (2) sont réalisées au moins en partie par moulage avec compatibilité du matériau.

7. Dispositif de détection suivant l'une des revendications 1 à 6, caractérisé par le fait que la microplaquette du capteur à semiconducteurs (1) et la microplaquette du dispositif amplificateur (2) sont fixées par collage ou brasage sur la languette unique commune de contact (7).

8. Dispositif de détection suivant l'une des revendications 1 à 6, caractérisé par le fait que la microplaquette du capteur à semiconducteurs (1) est fixée par collage ou brasage sur une languette de contact (7a) et que la microplaquette du dispositif amplificateur (2) est fixée par collage ou brasage sur une autre languette de contact (7b).

9. Dispositif de détection suivant l'une des revendications 1 à 8, caractérisé par le fait que la structure de contact (6) est formée d'une bande métallique (20) obtenue par un découpage conforme.

10. Dispositif de détection suivant l'une des revendications 1 à 9, caractérisé par le fait que le dispositif de détection est enrobé dans la composition de scellement (21) isolante de telle sorte que les bandelettes de contact (8,10 et 9), qui forment les raccordements d'alimentation (3,4) et le raccordement de sortie (5), soient partiellement en saillie et qu'il ne soit pas porté atteinte à la sensibilité du capteur à semiconducteurs (1).

11. Dispositif de détection suivant l'une des revendications 1 à 10, caractérisé par le fait que le capteur à semiconducteurs (1) est un dispositif photosensible, notamment une diode réceptrice à infrarouge.

12. Dispositif de détection suivant l'une des revendications 10 et 11, caractérisé par le fait que la composition de scellement (21) isolante est transparente et notamment transparente au rayonnement infrarouge.

13. Dispositif de détection suivant l'une des revendications 1 à 12, caractérisé par le fait qu'il est prévu un dispositif de blindage (30; 31), apte à protéger le dispositif de détection de champs électriques et magnétiques parasites et/ou de l'incidence de la lumière.
